# EUROPEAN PATENT SPECIFICATION

(11) **EP 0 638 801 B1**
(45) Date of publication and mention of the grant of the patent: **23.12.1998**
(21) Application number: 93480113.5
(22) Date of filing: 12.08.1993
(51) Int. Cl.: G01N 21/88, G01R 31/308, H05K 13/08

(54) **Method of inspecting the array of balls of an integrated circuit module**
Verfahren zur Inspektion vom Verbindungskugel-Satz eines intergrierten Schaltungsmoduls
Procédé d'inspection de l'ensemble de billes de connexion d'un module à circuit intégré

(43) Date of publication of application: 15.02.1995
(73) Proprietor: International Business Machines Corporation, Armonk, N.Y. 10504 (US)
(72) Inventor: Collet-Beillon, Olivier, F-78400 Chatou (FR)
(74) Representative: de Pena, Alain

(56) References cited:
- EP-A- 0 471 196
- EP-A- 0 472 041
- US-A- 4 296 474
- US-A- 5 058 178
- PROCEEDINGS 1987 IEEE INTERNATIONAL CONFERENCE ON ROBOTICS AND AUTOMATION, Raleigh, US, 31 March - 3 April 1987, pages 509 - 514 W.E. BLANZ ET AL. 'Image analysis methods for solder ball inspection in integrated circuit manufacturing'
- RESEARCH DISCLOSURE January 1992 , HAVANT GB RD33317 'Solder ball connection (SBC) co-planarity with X-ray technology'

## Description

The invention relates to the inspection methods used in the manufacturing of integrated circuit modules, and relates particularly to a method of inspecting the array of balls used for outside connections in an integrated circuit module in order to determine if the inspected module meets the manufacturing specifications.

In many integrated circuit modules and in particular SBC (Solder Ball Connection) modules, balls replace the conventional connection pins. The substrate generally includes a plurality of circuitry layers which connect the chips together and to the balls utilized as inputs/outputs. Then, such modules are soldered on printed circuit board by means of a matrix of conductive pads.

The overall reliability of the bonds created by the soldered ball process is adversely affected by defective balls. For example, if a ball has an insufficient height, then no electrical connection is made between the ball and the corresponding pad of the circuit board.

In the past, there have been proposed various kinds of bonding inspection machines. Thus, US patent 4,688,939 describes an inspection machine of solder bumps by placing the chip carrier on a platform beneath a ring light which is in registration with a television camera. Light which is directed at an angle towards all sides of the chip carrier is only reflected upwardly into the camera by the solder bumps. The output signal of the camera which varies with the intensity of the light reflected from the bumps, is processed by a vision system to obtain a one-dimensional intensity plot of the light intensity. The one-dimensional plot is analysed automatically by the system to detect for missing or excessive solder bumps on the chip carrier.

Likewise, US patent 5,058,178 relates to an apparatus wherein defective or missing solder bumps of a chip carrier are detected by first illuminating the carrier with dark field illumination. Next, the image of the surface is captured by a television camera. The captured image is processed to detect defects by first creating a window in the image about each group of solder bumps and then creating a bounding box about each bump in each window. Each of a set of attributes including the number, size and location of the windows, the size location and number of boxes in each window, and the dimensions shape and brightness of the image in each box, is measured. The value of each attribute is compared to a reference value representing the value of the attribute when no defects are present. If the attribute differs by more than a predetermined tolerance for its reference value, this is indicative of a particular defect.

European Application EP-A-0 471 196 discloses an image analysis of a relief image - especially to inspect soldered joints on circuits boards, involving simultaneous recording two-dimensional grey image in digitized form. In image analysis which has been recorded three-dimensional by triangulation and digitized, in which classification is carried out using extracted image characteristics, especially for automatic visual inspection of soldered joints on circuits boards, a two-dimensional grey image is simultaneously recorded in digitized form and, for each image point to be processed, the corresponding values of the relief image and the grey image are simultaneously used in the image characteristic extraction operation.

The image characteristics extracted from the grey image are preferably used to test plausibility of corresponding image characteristics of the relief image. A misting device may be used to mist the surface of a test object for comparison of reflective properties, misting preferably being carried out using an almost water-saturated air stream.

Inspection machines implemented until now have been used to check each solder bump and verify whether the bump meets some requirements so that it can be considered as having a defect or not. But now none of these machines inspects the whole array of bumps or balls to determine whether the bumps or balls are correctly located with respect to other bumps or balls of the array.

The object of the invention is therefore to provide an automatic method of inspecting an array of balls used for outside connections in an integrated circuit module in order to determine whether the module is acceptable for manufacturing conditions.

Another object of the invention is to provide an automatic method of inspecting the centrality and the flatness of an array of balls used for outside connections in an integrated circuit module.

Still another object of the invention is to provide an automatic method of inspecting an array of balls used for outside connections in an integrated circuit module by checking the alignment and the flatness of the balls between them without utilising an absolute reference like the edge of the substrate.

Accordingly, the present invention relates to a method of inspecting an array of balls used as connections in integrated circuit modules such as Solder Ball Connection modules, by means of an inspection machine comprising a microprocessor, a light source, a table on which is placed the module to be inspected, the coordinates of the table being controlled by the microprocessor, and at least one camera connected to the microprocessor for obtaining images of the balls lighted by the light source. The method consists in measuring the coordinates X and Y of each ball of the array of balls in order to determine a best fitting grid of the balls, detecting the coordinate Z of each ball in order to determine a best fitting plan for the array of balls, offsetting the best fitting plan so that the offset plan includes the lower ball of the array of balls, computing the deviation between each ball of the array of balls and the offset plan, and comparing the computed deviations with predetermined specifications to determine whether the module is in compliance with the specifications.

This object and further objects, features and advantages of the subject invention will become more evident with the following description read in connection with the accompanying drawings wherein:
Figure 1 discloses a module of the type Solder Ball Connection module used in the inspection method according to the invention,
Figure 2 shows a cross-section of a ball soldered to the pad of the module substrate,
Figure 3 is a schema of the module soldered by balls to a printed circuit card,
Figure 4 is a bloc diagram of the system used in the inspection method according to the invention,
Figure 5 represents three examples of ball arrays which can be inspected during the inspection method according to the invention,
Figure 6 discloses the way the successive views of groups of balls are recorded in the method used to determine the centrality of the array of balls,
Figure 7 represents three diagrams showing the deviations to be taken into account when the height of the balls is determined,
Figure 8 discloses schematically the system used to determine the flatness of the array of balls in the inspection method according to the invention,
Figure 9 is a photograph showing the view of the lighted balls during the method according to the invention,
Figure 10 is a schema illustrating the correction to be brought in the height determination when the ball is not at its theoretical position,
Figure 11 illustrates schematically the misalignment between the camera and the table carrying the module to be inspected,
Figure 12 represents a pair of juxtaposed views including a drift between the first and the second views,
Figure 13 represents a pair of juxtaposed views separated by a gap due to the scale problem,
Figure 14 illustrates schematically the deviation between the image plan and the vertical plan in the determination of the Z scale, and
Figure 15 discloses schematically the light ring used as light source in the inspection method according to the invention.

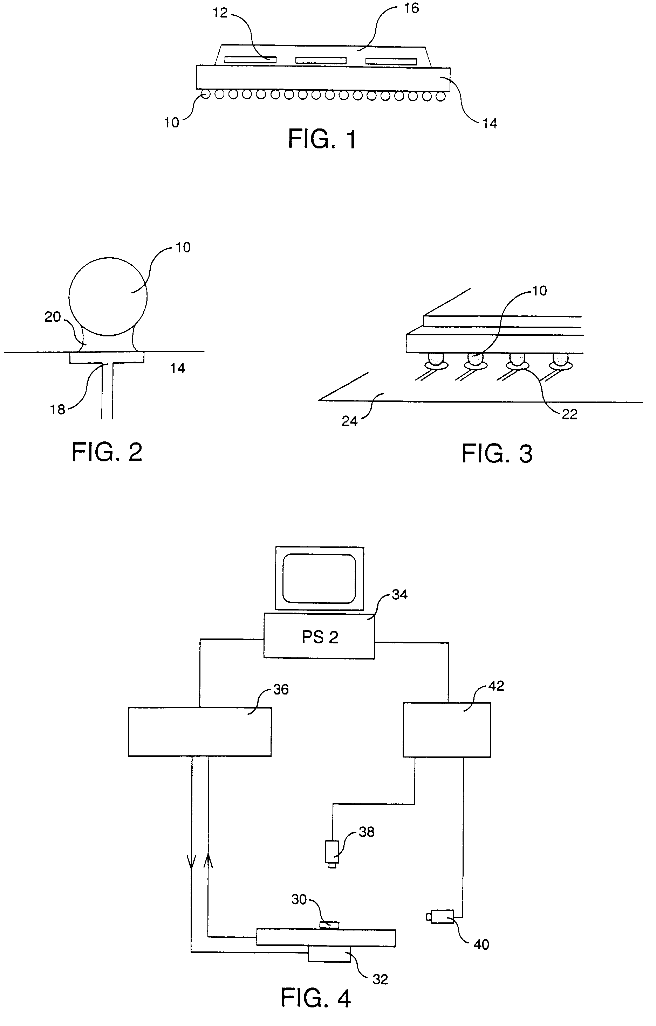

The module to be inspected is generally of the type Solder Ball Connection (SBC) module shown in Figure 1. For this kind of module, the balls 10 replace the conventional pins used to achieve the connections. Substrate 14 contains a plurality of circuitry layers which connect chips 12 together and to the balls used as input/output connections. The chips are enclosed by a cap 16 for each module. As shown in Figure 2, each ball 10 is connected to a pad 18 of substrate 14 by a point of solder 20.

Several modules are then soldered on a printed circuit card by soldering the balls on the receiving pads 22 of the card 24 as shown in Figure 3. If the array of balls soldered on the module is not plane, some balls 10 may be too far from the pad 22 to be soldered thereto, and finally, the connection is not achieved with the card. Also, if the matrix of balls is not regular, some balls may not be facing the corresponding pads, and again the connection will not be achieved because the balls will not be soldered to their pads.

### METHOD OF INSPECTION

The method of inspection according to the present invention enables the array of balls to be inspected with high accuracy and high speed. Such a method is accomplished by means of an inspection machine illustrated in Figure 4. A module 30 is positioned on a motorised table which is movable according to axis X and axis Y. The motion of table 32 is controlled by microprocessor 34 (which can be, for example, an IBM PS/2), via the control unit 36. The table can be moved so that the coordinates X and Y of the modules can be adjusted very precisely.

To perform the inspection of the ball positions in the plane coordinates X, Y as well as for the height with respect to the horizontal plane, two cameras 38 and 40 are used. As will be described hereafter, camera 38 is used to measure the centrality of the ball array, and camera 40 is used to sense the flatness of the array. The two cameras 38 and 40 are connected to a controller 42 which is itself connected to microprocessor 34. Controller 42 processes the vision algorithms, computes the results, adjusts the light intensity, and selects the camera, whereas microprocessor 34 performs all controls, synchronises the axes motion with the vision process and is used to interface with the operator.

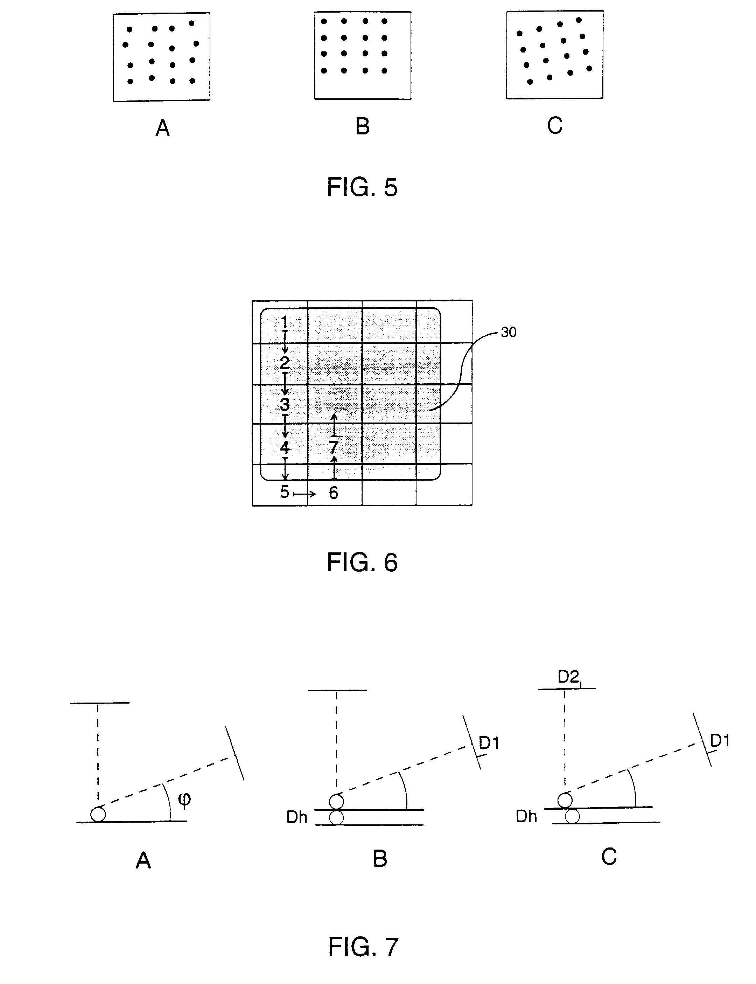

The first step of the inspection method according to the invention consists in checking the regularity of the ball array or measuring the centrality of the array. The principle is not to sense the position of each ball with respect to an absolute reference like the edge of the substrate, but to define the position of each ball in the array of balls regarding the other balls of the array. Thus, three modules are illustrated in Fig 5. The first module A has its array of balls which forms an irregular matrix. Such a module will be discarded. Conversely, module B which has a shifted matrix of balls, and module C which has a turned matrix of balls, can be kept because, in both cases, the matrix of balls is regular.

Practically, the step consists in measuring accurately the position of each ball, computing a best fitting grid which is a theoretical grid matching at best all the balls, and finally computing the deviation between each ball and its theoretical position in the best fitting grid. Such a measure is achieved by means of the vertical camera 38 (sec Fig 4) which takes successive views of the array of balls in the manner illustrated in Fig. 6 showing the module 30 in grey. Each view 1, 2, 3, ... 6, 7 can correspond to a matrix of m x n balls. Thus, one view can take the image of 20 balls corresponding to a matrix of 4 x 5. The parameters m and n are determined by the distance of which the table carrying the module is moved each time a view has to be taken. It must be noted that the way the views are taken, sometimes called "Boustrophedon", results in the scanning of the whole module in a minimum time.

After all the views have been taken, they have to be combined in order to build the image of the module. This raises some problems due to the misalignment of the camera with respect to the table. Such problems resulting from the image "drift" are solved by the calibration step which will be described later.

The image magnification and the scale depend on the distance object/camera. Thus, if the distance grows, the magnification becomes small. The specifications on the thickness of the module are large, for instance 0,9 mm. But the scales are false for a difference as small as 0,1 mm. From a cycle point of view, it is not possible to calibrate the tool for each module. So, the distance module/camera must be adapted to the memorised scales for each module. The machine inspection uses two cameras with different view angles resulting in the ability to process stereo-vision in order to determine any height variation. Two different views are processed from the same object and a 3D information is computed. This information is compared with an information memorised during the calibration step described hereafter, and Z axis is automatically adjusted to have a constant height between the camera and the module. Such a method enables to determine a 10µ deviation.

As illustrated in Figure 7, the height difference for each module is determined easily by means of the two cameras. In diagram A, there is no height difference and no adjustment is necessary. In diagram B, the height difference Dh is determined by measuring the deviation D1 measured by the flatness (tilted) camera.$\text{Dh =} \frac{\text{D1}}{\text{cosϕ}}$

In diagram C, further to the difference in height, there is also a difference in position detected as D2 by the vertical camera. In such a case, the height difference is:$\text{Dh =} \frac{\text{D1 + D2.sinϕ}}{\text{cosϕ}}$

When the height difference has been accurately determined by measuring it for several balls and taking the average, the vertical camera is moved of the distance Dh before processing further.

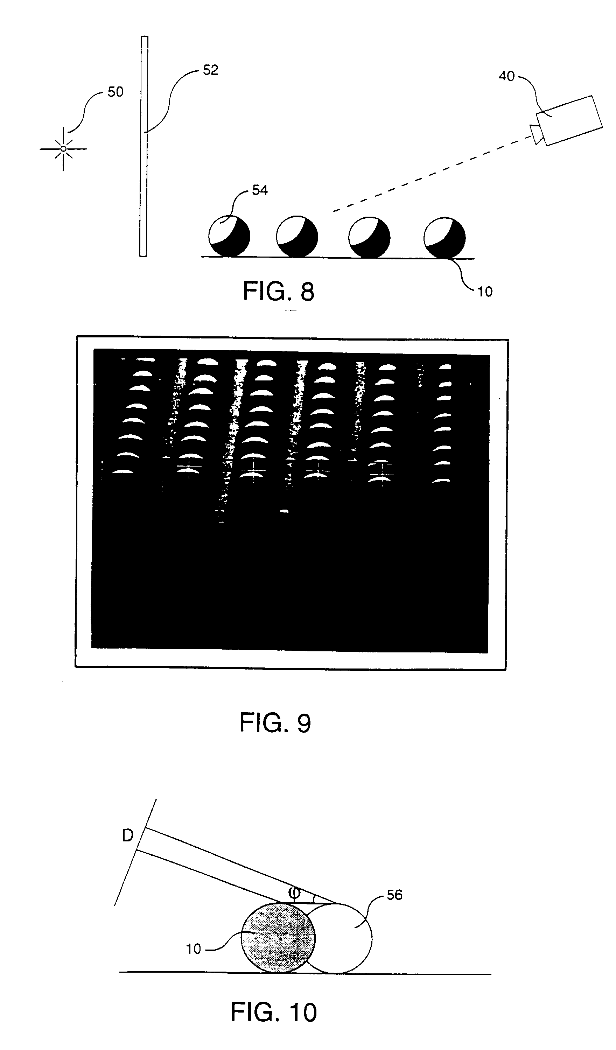

Then, the height of the balls is determined by taking a view for each group of 4 balls. As shown on figure 8, a light source 50 is located opposite camera 40. In order to obtain a diffused light, a diffuser 52 is disposed between light source 50 and the balls 10. With such a light system it is very easy for the camera to take a view of the light reflection 54 at the top of the balls as illustrated in figure 9 by the four crosses represented on the top of the 4 balls.

For each ball, a correction of the height is necessary because ball 10 is not at its theoretical position 56 as shown in figure 10. Such a deviation with respect to the theoretical Y coordinate is known by measuring the alignment of the balls and determining the theoretical grid as already described. With the angle of the camera being Y, the correction value to be applied to the view is$\text{D = L. sin ϕ}$ with L being the deviation of the ball with respect to its theoretical position.

Then, the table is moved to take a view of the next four balls. The way of taking the views of the balls (Boustrophedon) is the same as the way the views are taken for measuring the alignment of the balls.

After the heights of the balls forming the array of balls have been determined, corrected and stored, a plane fitting at most the top of the balls, called hereafter the "best fitting plane" is computed using the Least Square Regression method.
If X(i,j); Y(i,j); Z(i,j) are the coordinates for each ball top, the equation for a plane including such a point is${\text{Z}}_{\text{plane}} \text{= a.X(i,j) + b.Y(i,j) + c}$

The squared distance between any object and the plane is${\text{E(i,j) = [Z}}_{\text{plane}} {\text{- Z(i,j)]}}^{\text{2}}$

The process consists in computing 3 parameters of the plane which minimize the sum of the squared distances$\text{D = sum E(i,j)}$ D is then derived with respect to the three unknown coefficients a, b, c, and the derivatives are made to zero.

Let us define${\text{S = Z}}_{\text{plane}} \text{- Z(i,j)}$$\text{S = a.X(i,j) + b.Y(i,j) + c - Z(i,j)}$

Therefore,$\text{dE(i,j)/d* = 2.dS/d*.S}$ where * stands for any of a, b, c.$\text{dE(i,j)/da = 2.X(i,j).[a.X(i,j)+b.Y(i,j)+ c-Z(i,j)]}$$\text{dE(i,j)/db = 2.Y(i,j).[a.X(i,j)+b.Y(i,j)+ c-Z(i,j)]}$$\text{dE(i,j)/dc = 2.[a.X(i,j)+b.Y(i,j)+ c -Z(i,j)]}$

These expressions are summed over the working set and the results are equated to zero.
S1 = sum X S4 = sum X² S6 = sum X.Y
S2 = sum Y S5 = sum Y² S7 = -sum X.Z
S3 = -sum Z S8 = -sum Y.Z

This gives (n being the number of objects in the working set$\text{0 = a.S4 + b.S6 + c.S1 + S7}$$\text{0 = a.S6 + b.S5 + c.S2 + S8}$$\text{0 = a.S1 + b.S2 + c.n + S3}$

Let us have$\text{(1).S6 - (2).S4}$$\text{0 = b.(S6.S6-S5.S4)+c.(S1.S6-S2.S4)+(S7.S6-S4.S8)} \text{(2).S1 - (3).S6}$$\text{0 = b.(S5.S1-S2.S6)+c.(S1.S2-n.S6)+(S8.S1-S3.S6)}$

Let us define
A=(S6.S6-S5.S4) C=(S7.S6-S4.S8) E=(S1.S2-n.S6)
B=(S1.S6-S2.S4) D=(S5.S1-S2.S6) F=(S8.S1-S3.S6)

Equations (4) and (5) become$\text{0 = b.A + c.B + C}$$\text{0 = b.D + c.E + F}$

Let us have$\text{(4).E - (5).B}$$\text{0 = b.(A.E - D.B) + (C.E - F.B)}$

This gives coefficient b$\text{b = -(C.E - F.B)/(A.E - D.B)}$

Then it is easy to get a and c$\text{a = -(b.S6 + c.S1 + S7)/S4}$$\text{c = -(B.D - A.E)/(D.C - A.F)}$

Then, the deviations between the balls of the array and the best fitting plane are computed. The best fitting plane is offset so that the new plane, or inspection plane, includes the top of the lowest ball of the array. Again, the deviations between the balls and the inspection plane are computed. Finally, the computed deviations are compared with the specifications whereby the module is accepted if the deviations meet the specifications or the module is discarded if the deviations do not meet the specifications.

### MACHINE CALIBRATION

The machine used for performing the process according to the invention being an alignment tool, the calibration is a particularly important step of the whole process. For a classical vision tool processing on a single image, the calibration phase consists in determining the ratio camera pixel/real size. This ratio is called "scale" and depends on the optical magnification.

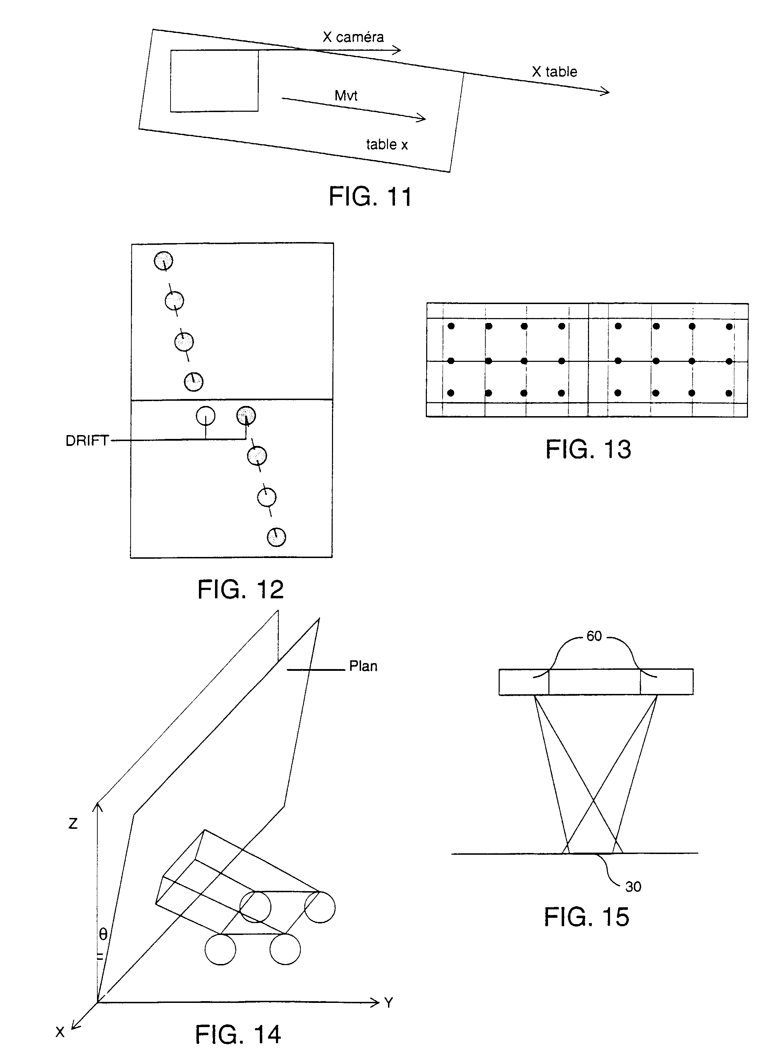

Preferably, a CCD (coupled charge device) camera is used. In such a camera, a pixel is not square, so the scale for the two axes X and Y has to be determined. Furthermore, one axis motion being done between two image acquisitions, we have also to take into account the drift resulting on the misalignment between the camera axis and the table axis as shown in Figure 11.

Accordingly, the calibration is achieved in two steps: a coarse calibration and a fine calibration. During the coarse calibration, in order to determine approximately the pixel scale, one image is snapped (20 balls for centrality and 4 balls for flatness), and the average of deviation between the balls is computed by combining them two by two.

The fine calibration gives, with high accuracy, the scales X and Y and the drifts X and Y for the centrality camera which is a vertical (if the X and Y table axes are not perpendicular, drift X is different from drift Y). For the flatness camera which is tilted at an angle of about 15° with respect to the horizontal plane, the calibration gives the scale Z and the reference for Z axis, that is the distance between the module and the vertical camera used for the centrality.

To perform a fine calibration, a complete module is processed by the inspection method according to the invention using the scale resulting from the coarse calibration.

The drift is illustrated in Figure 12 showing two successive views. The slope of the module is computed by averaging all the balls of each view and aver all the views. Such a slope is called "correction" (CORR). The variation from a view to the following view (VARI) is averaged on all the balls located on the image edges.$\text{DRIFT = VARI (x,y) - CORR (x,y)}$

As far as the scale is concerned, such a problem is illustrated in Figure 13 showing two views separated by a gap due to the scale problem. This problem is easily solved by noticing that, if R is the ratio of the value of the distance between the balls of the views, it is also the ratio of the used scale to the real scale. Therefore, once R is computed, it is very easy to rectify the scale. It must be noted that the distances between balls are averaged on the whole module resulting in a high accuracy.

For the flatness measurements, it is necessary to determine the Z scale. For this, we need to know the angle θ between the image plane and the vertical plane as illustrated in Figure 14. If RS is the real scale and SS the seen scale, the following equations can be set:$\text{RS(X) = SS(X)}$$\text{RS(Y) = SS(X).R}$$\text{sinθ =} \frac{\text{SS(Y)}}{\text{RS(Y)}}$$\text{Scale(Z) =} \frac{\text{RS(Y)}}{\text{cosθ}}$

With reference to Figure 15 it must be noted that, in order to obtain an image including the balls without any shadow which could disturb the measuring process, a non-directed and homogeneous light source called a "light ring" 60 is used to light module 30 during the whole inspection process. Such a light ring composed of 100 LEDs is very advantageous in that it does not provide much heat which would constitute a nuisance for achieving the inspection.

## Claims

1. A method of inspecting an array of balls (10) used as connections in integrated circuit modules (30) such as Solder Ball Connection modules, by means of an inspection machine comprising a microprocessor (34), at least a light source (50), a table on which is placed the module to be inspected, the coordinates of said table being controlled (32) by said microprocessor, and at least one camera (38, 40) for obtaining images of the balls lit by said light source, said at least one camera being connected to said microprocessor; said method being characterised by the steps of:
measuring the coordinates X and Y of each ball of said array of balls in order to determine a best fitting grid of the balls,
detecting the coordinate Z of each ball in order to determine a best fitting plane for said array of balls,
offsetting said best fitting plane so that the offset plane includes the lower ball of said array of balls,
computing the deviation between each ball of said array of balls and said offset plane, and
comparing the computed deviations with predetermined specifications to determine whether said module is in compliance with said specifications.

2. The method according to claim 1 wherein the step of determining the best fitting grid of the balls consists in:
measuring accurately the position of each ball (10) in said array of balls of each module (30),
computing, from the coordinates of all the balls in said array of balls, a theoretical grid (best fitting grid) which matches all the balls at best, and
computing the deviation between each ball and its theoretical position in said best fitting grid.

3. The method according to claim 2 wherein said step of measuring accurately the position of each ball (10) in said array of balls consists in taking views of successive juxtaposed parts of the array of balls (fig. 6) by means of a vertical camera (38), each part comprising m x n balls.

4. The method according to claim 1 2, or 3 wherein said step of detecting the coordinate Z of the top of each ball (10) in said array of balls consists in taking views of successive juxtaposed rows (fig. 9) of the array of balls by means of an tilted camera (40), with the balls being lit by a light source (50) located opposite said camera with respect to said array of balls so that the image of a ball taken by said camera in each view corresponds to a light reflection at the top of said ball.

5. The method according to claim 4 wherein said step of determining the best fitting plane for said array of balls consists in applying the Least Square Regression method to the computation of the plane parameters which minimizes the sum of the squared distances between it and the balls.

6. The method according to claim 2 and 4 or 5 wherein the coordinate Z of the top of each ball (10) detected by means of said tilted camera (40) is corrected taking into account the deviation of the position of said ball with respect to its theoretical position (fig. 10) in said best fitting grid.

7. The method according to claim 4, 5 or 6 wherein, before said step of detecting the coordinate Z of the top of each ball (10), the height of each module (30) with respect to said vertical camera (38) is adjusted so as to take the module thickness into account.

8. The method according to any one of the preceding claims wherein a calibration phase including a coarse calibration followed by a fine calibration is performed prior to any inspection process applied to modules, so as to determine the scale and the drift to take into account during the inspection phase.

9. The method according to claim 8 wherein said coarse calibration consists in snapping an image of an array of balls and computing the average of deviation between balls by combining them two by two in order to determine approximately the pixel scale.

10. The method according to claim 8 or 9 wherein the phase of fine calibration is performed by applying to a module the steps of the inspection method using the scale resulting from said coarse calibration; said fine calibration consisting in:
determining the drift resulting from the misalignment between the camera axis and the table axis by computing the difference between the value of the variation from a view to the adjacent view taken by a vertical camera (38) and the slope of the module with respect to the supporting table,
determining the X and Y scales by computing the ratio of the value of the distance between the balls of a view to a value of the distance between the balls of two views, said views being taken by said vertical camera, and
determining the Z scale by using the angle θ between the vertical plan and the image plan when a view is taken with an tilted camera (40).

11. An inspection machine for inspecting an array of balls (20) used as connections in integrated circuit modules (30) such as Solder Ball Connection modules, using the method according to any one of the preceding claims, said inspection machine comprises:
a microprocessor (34),
at least a light source (50),
a table on which is placed the module (30) to be inspected , the coordinates of said table being controlled by said microprocessor,
a vertical camera (38) mainly used to determine the centrality of said array of balls,
an tilted camera mainly used to determine the flatness of said array of balls, and
a controller (42) interconnected between said microprocessor (34) and said vertical and tilted cameras for processing the vision algorithms and transferring the results to said microprocessor.

12. The inspection machine according to claim 11 wherein said at least light source is composed of light emitting diodes (LED) in the form of a light ring.

## Patentansprüche

1. Ein Prüfverfahren für eine Kugelanordnung (10), die als Anschlüsse in integrierten Schaltungsmodulen (30), wie z.B. Lötkugel-Anschluß-Module, benutzt werden mittels einer Prüfmaschine, enthaltend einen Mikroprozessor (34), wenigstens eine Lichtquelle (50), einen Tisch, auf den das zu prüfende Modul gelegt wird, wobei die Koordinaten des Tisches vom Mikroprozessor gesteuert werden (32), und wenigstens eine Kamera (38, 40), um Abbildungen der von der Lichtquelle beleuchteten Kugeln aufzunehmen, wobei diese wenigstens eine Kamera mit dem Mikroprozessor verbunden ist; wobei dieses Verfahren durch die folgenden Schritte gekennzeichnet ist:
Messen der Koordinaten X und Y jeder Kugel der Kugelanordnung, um ein am besten passendes Gitter für die Kugeln zu erhalten;
Erfassen der Z-Koordinate jeder Kugel, um die am besten passende Ebene für die Kugelanordnung zu erhalten;
Verschieben der am besten passenden Ebene, so daß die verschobene Ebene die untere Kugel der Kugelanordnung einschließt;
Berechnen der Abweichung zwischen jeder Kugel der Kugelanordnung und der verschobenen Ebene; und
Vergleichen der berechneten Abweichungen mit vorgegeben Spezifikationen, um festzustellen, ob das Modul mit den Spezifikationen übereinstimmt.

2. Das Verfahren gemäß Anspruch 1, in dem der Schritt zum Bestimmen des am besten passenden Gitters der Kugeln besteht aus:
dem genauen Messen der Position jeder Kugel (10) in der Kugelanordnung jedes Moduls (30);
Berechnen eines theoretischen Gitters (das am besten passende Gitter) aus den Koordinaten aller Kugeln in der Kugelanordnung, das alle Kugeln am besten erfaßt; und
Berechnen der Abweichung aller einzelnen Kugeln von ihrer theoretischen Position im am besten passenden Gitter.

3. Das Verfahren gemäß Anspruch 2, in dem der Schritt zum genauen Messen der Position jeder Kugel (10) in der Kugelanordnung aus dem Aufnehmen von Ansichten der Reihe nach nebeneinanderliegender Teile der Kugelanordnung (Fig. 6) mittels einer vertikalen Kamera (38) besteht, wobei jeder Teil m x n Kugeln umfaßt.

4. Das Verfahren gemäß Anspruch 1, 2 oder 3, in dem der Schritt zum Erfassen der Koordinate Z der obersten Stelle jeder Kugel (10) in der Kugelanordnung aus dem Aufnehmen von Ansichten aufeinanderfolgender, nebeneinanderliegender Zeilen (Fig. 9) der Kugelanordnung mittels einer gekippten Kamera (40) besteht, wobei die Kugeln von einer Lichtquelle (50) beleuchtet werden, die der Kamera im Verhältnis zur Kugelanordnung gegenüber liegen, so daß das Bild einer von dieser Kamera aufgenommenen Kugel einer Lichtreflexion von der obersten Stelle der Kugel entspricht.

5. Das Verfahren gemäß Anspruch 4, in dem der Schritt zum Bestimmen des am besten passenden Gitters der Kugeln der Anordnung aus dem Anwenden der Methode der Regression der Kleinsten Quadrate zur Berechnung der Ebenen-Parameter besteht, die die Summe der Quadrate der Abstände zwischen ihr und den Kugeln minimiert.

6. Das Verfahren gemäß Anspruch 2 und 4 oder 5, in dem die Koordinate Z oben auf jeder Kugel (10), die mittels der gekippten Kamera (40) erfaßt wird, korrigiert wird unter Berücksichtigung der Abweichung von der Position der betreffenden Kugel von ihrer theoretischen Position (Fig. 10) in dem am besten passenden Gitter.

7. Das Verfahren gemäß Anspruch 4, 5 oder 6, in dem vor dem Schritt zur Erfassung der Koordinate Z oben auf jeder Kugel (10) die Höhe jedes Moduls (30) bezüglich der vertikalen Kamera (38) ausgerichtet wird, so daß die Moduldicke berücksichtigt wird.

8. Das Verfahren gemäß einem beliebigen der vorstehenden Ansprüche, in dem eine Kalibrierphase ausgeführt wird, die eine Grobkalibrierung gefolgt von einer Feinkalibrierung umfaßt, bevor ein Prüfprozeß auf das Modul angewandt wird, so daß der Maßstab und die Drift bestimmt werden, die bei der Prüfphase in Betracht gezogen werden müssen.

9. Das Verfahren gemäß Anspruch 8, in dem die Grobkalibrierung aus dem Einfangen eines Bildes einer Kugelanordnung und Berechnen des Mittelwerts der Abweichung zwischen den Kugeln durch paarweises Kombinieren derselben besteht, um in etwa den Pixel-Maßstab zu bestimmen.

10. Das Verfahren gemäß Anspruch 8 oder 9, in dem die Phase der Feinkalibrierung durch Anwenden der Schritte der Prüfmethode unter Verwendung des Maßstabs aus der Grobkalibrierung durchgeführt wird, wobei die Feinkalibrierung aus den folgenden Schritten besteht:
Bestimmen der sich aus der Fehlanpassung zwischen der Kameraachse und der Tischachse ergebenden Drift durch Berechnen des Unterschieds zwischen dem Wert der Veränderung zwischen einer Ansicht zur nebenliegenden Ansicht, die durch die vertikale Kamera (38) aufgenommen wird, und der Schräge des Moduls gegenüber dem Auflagetisch;
Bestimmen der X- und Y-Maßstäbe durch Berechnen des Verhältnisses der Größe des Abstandes zwischen den Kugeln einer Ansicht und einer Größe des Abstandes zwischen den Kugeln von zwei Ansichten, wobei diese Ansichten von der vertikalen Kamera aufgenommen werden; und
Bestimmen des Z-Maßstabs durch Benutzen des Winkels θ zwischen der vertikalen Ebene und der Bildebene, wenn eine Aufnahme mit einer gekippten Kamera (40) gemacht wird.

11. Eine Prüfmaschine zum Prüfen einer Kugelanordnung (20), die als Verbindungen in integrierten Schaltungsmodulen (30), wie z.B. Lötkugelverbindungsmodule, gemacht wird, unter Verwendung des Verfahrens gemäß einem beliebigen der vorstehenden Ansprüche, wobei die Prüfmaschine umfaßt:
einen Mikroprozessor (34);
mindestens eine Lichtquelle (50);
einen Tisch, auf den das zu prüfende Modul (30) gelegt wird, wobei die Koordinaten des Tisches vom Mikroprozessor gesteuert werden;
eine vertikale Kamera (38), die in der Hauptsache benutzt wird, um die Zentralität der Kugelanordnung zu bestimmen;
eine gekippte Kamera, die in der Hauptsache benutzt wird, um die Ebenheit der Kugelanordnung zu bestimmen; und
einen Controller (42), der zwischen dem Mikroprozessor (34) und der vertikalen und der gekippten Kamera eingeschaltet ist, um die Sicht-Algorithmen zu verarbeiten und die Ergebnisse an den Mikroprozessor weiterzuübertragen.

12. Die Prüfmaschine gemäß Anspruch 11, in der die wenigstens eine Lichtquelle aus Lichtemitterdioden (LED) in der Form eines Lichtrings zusammengesetzt ist.

## Revendications

1. Procédé pour contrôler une matrice de billes (10) utilisées comme connexions dans des modules à circuit intégré (30) tels que des modules de Connexion par Billes de Soudure au moyen d'une machine de contrôle comprenant un microprocesseur (35), au moins une source lumineuse (50), une table sur laquelle est placé le module à contrôler, les coordonnées de ladite table étant commandées (32) par ledit microprocesseur, et au moins une caméra (38, 40) pour obtenir des images des billes éclairées pour ladite source lumineuse, ladite au moins une caméra étant reliée audit microprocesseur ; ledit procédé étant caractérisé par les étapes consistant à :
mesurer les coordonnées X et Y de chaque bille de ladite matrice de billes afin de déterminer une grille de meilleur ajustement des billes,
détecter la coordonnée Z de chaque bille afin de déterminer le meilleur plan d'ajustement pour ladite matrice de billes,
décaler ledit plan de meilleur ajustement de sorte que le plan décalé comprend la bille inférieure de ladite matrice de billes,
calculer l'écart entre chaque bille de ladite matrice de billes et ledit plan décalé, et
comparer les écarts calculés aux spécifications prédéterminées afin de déterminer si ledit module est en conformité avec lesdites spécifications.

2. Procédé selon la revendication 1, dans lequel l'étape consistant à déterminer la meilleure grille d'ajustement des billes est constituée des étapes consistant à :
mesurer précisément la position de chaque bille (10°) dans ladite matrice des billes de chaque module (30),
calculer, à partir des coordonnées de toutes les billes dans ladite matrice de billes, une grille théorique (grille de meilleur ajustement) qui adapte au mieux toutes les billes, et
calculer l'écart entre chaque bille et sa position théorique dans la meilleure grille d'ajustement.

3. Procédé selon la revendication 2, dans lequel ladite étape consistant à mesurer précisément la position de chaque bille (10) dans ladite matrice de billes consiste à prendre des vues des parties successives juxtaposées de la matrice de billes (figure 6) au moyen d'une caméra verticale (38), chaque partie comprenant m x n billes.

4. Procédé selon la revendication 1, 2 ou 3, dans lequel ladite étape consistant à détecter la coordonnée Z du sommet de chaque bille (10) dans ladite matrice de billes consiste à prendre des vues des rangées successives juxtaposées (figure 9) de la matrice des billes au moyen d'une caméra inclinée (40), les billes étant éclairées par une source lumineuse (50) positionnée opposée à ladite caméra par rapport à ladite matrice de billes de sorte que l'image d'une bille prise par ladite caméra dans chaque vue correspond à la réflexion de la lumière au sommet de ladite bille.

5. Procédé selon la revendication 4, dans lequel ladite étape consistant à déterminer le meilleur plan d'ajustement pour ladite matrice de billes consiste à appliquer le procédé de Régression des Moindres Carrés au calcul des paramètres du plan qui minimisent la somme des distances quadratiques entre celle-ci et les billes.

6. Procédé selon la revendication 2 et 4 ou 5 dans lequel la coordonnée Z du sommet de chaque bille (10) détectée au moyen de ladite caméra inclinée (40) est corrigée en prenant en compte l'écart de la position de ladite bille par rapport à sa position théorique (figure 10) dans la meilleure grille d'ajustement.

7. Procédé selon la revendication 4, 5 ou 6 dans lequel, avant ladite étape consistant à détecter la coordonnée Z du sommet de chaque bille (10), la hauteur de chaque module (30) par rapport à ladite caméra verticale (38) est ajustée de façon à prendre en compte l'épaisseur du module.

8. Procédé selon l'une quelconque des revendications précédentes dans lequel une phase d'étalonnage incluant un étalonnage grossier suivi par un étalonnage fin est effectuée avant tout procédé de contrôle quelconque appliqué aux modules, de façon à déterminer l'échelle et la dérive à prendre en compte pendant la phase de contrôle.

9. Procédé selon la revendication 8 dans lequel ledit étalonnage grossier est constitué de la prise rapide d'une image d'une matrice de billes et du calcul de la moyenne de l'écart entre les billes en les combinant deux par deux dans l'ordre afin de déterminer approximativement l'échelle de pixels.

10. Procédé selon la revendication 8 ou 9, dans lequel la phase de l'étalonnage fin est effectuée en appliquant au module les étapes du procédé de contrôle en utilisant l'échelle obtenue à partir de l'étalonnage grossier, ledit étalonnage fin étant constitué par les étapes consistant à :
déterminer la dérive résultant du désalignement entre l'axe de la caméra et l'axe de la table en calculant la différence entre la valeur de la variation d'une vue à la vue adjacente prise par une caméra verticale (38) et la pente du module par rapport à la table de support,
déterminer les échelles X et Y en calculant le rapport de la valeur de la distance entre les billes d'une vue à une valeur de la distance entre les billes de deux vues, lesdites vues étant prises par ladite caméra verticale, et
déterminer l'échelle Z en utilisant l'angle θ entre le plan vertical et le plan image lorsqu'une vue est prise avec une caméra inclinée (40).

11. Machine de contrôle pour contrôler une matrice de billes (20) utilisée comme connexions dans des modules à circuit intégré (30) tels que des modules de Connexion par Billes de Soudure, utilisant le procédé selon l'une quelconque des revendications précédentes, ladite machine de contrôle comprend :
un microprocesseur (34),
au moins une source lumineuse (50),
une table sur laquelle est placé le module (30) à contrôler, les coordonnées de ladite table étant commandées par ledit microprocesseur,
une caméra verticale (38) utilisée principalement pour déterminer le centre de ladite matrice des billes,
une caméra inclinée utilisée principalement pour déterminer la planéité de ladite matrice des billes, et
un contrôleur (42) interconnecté entre ledit microprocesseur (34) et lesdites caméras verticale et inclinée pour traiter les algorithmes de vision et transférer les résultats audit microprocesseur.

12. Machine de contrôle selon la revendication 11, dans laquelle ladite au moins une source de lumière est constituée de diodes à émission de lumière (DEL) sous la forme d'un anneau lumineux.
